# EUROPEAN PATENT APPLICATION

(11) **EP 3 690 968 A1**
(43) Date of publication of application: **05.08.2020**
(21) Application number: 19155093.8
(22) Date of filing: 01.02.2019
(51) Int. Cl.: H01L 41/08, H01L 41/193

(54) **ACTUATOR DEVICE BASED ON AN ELECTROACTIVE MATERIAL**

(71) Applicant: Koninklijke Philips N.V., 5656 AG Eindhoven (NL)
(72) Inventor: PELSSERS, Eduard Gerard Marie, 5656 AE Eindhoven (NL); JOHNSON, Mark Thomas, 5656 AE Eindhoven (NL); VAN DEN ENDE, Daan Anton, 5656 AE Eindhoven (NL); HILGERS, Achim Rudolf, 5656 AE Eindhoven (NL)
(74) Representative: de Haan, Poul Erik

(57) **Abstract**

An actuator device has an ionic electroactive material actuator unit comprising a membrane with first and second actuation electrodes on opposite first and second surfaces, respectively. A DC drive signal is applied between the actuation electrodes. In addition, a pair of closely spaced measurement electrodes is provided on the first surface of the membrane. A local surface-effect impedance change is preferably used as the basis of a signal measurement, for providing feedback relating to the state of actuation of the device.

## Description

### FIELD OF THE INVENTION

This invention relates to actuator devices which make use of electroactive materials, such as electroactive polymers.

### BACKGROUND OF THE INVENTION

Electroactive polymers (EAP) are an emerging class of materials within the field of electrically responsive materials. EAPs can work as sensors or actuators and can easily be manufactured into various shapes allowing easy integration into a large variety of systems.

Materials have been developed with characteristics such as actuation stress and strain which have improved significantly over the last ten years. Technology risks have been reduced to acceptable levels for product development so that EAPs are commercially and technically becoming of increasing interest. Advantages of EAPs include low power, small form factor, flexibility, noiseless operation, accuracy, the possibility of high resolution, fast response times, and cyclic actuation.

The improved performance and particular advantages of EAP material give rise to applicability to new applications.

An EAP device can be used in any application in which a small amount of movement of a component or feature is desired, based on electric actuation. Similarly, the technology can be used for sensing small movements.

The use of EAPs enables functions which were not possible before, or offers a big advantage over common sensor / actuator solutions, due to the combination of a relatively large deformation and force in a small volume or thin form factor, compared to common actuators. EAPs also give noiseless operation, accurate electronic control, fast response, and a large range of possible actuation frequencies, such as 0 - 20 kHz.

Devices using electroactive polymers can be subdivided into field-driven and ionic-driven materials.

Examples of field-driven EAPs are dielectric elastomers, electrostrictive polymers (such as PVDF based relaxor polymers or polyurethanes) and liquid crystal elastomers (LCE).

Examples of ionic-driven EAPs are conjugated polymers, carbon nanotube (CNT) polymer composites and Ionic Polymer Metal Composites (IPMC).

Field-driven EAPs are actuated by an electric field through direct electromechanical coupling, while the actuation mechanism for ionic EAPs involves the diffusion of ions. Both classes have multiple family members, each having their own advantages and disadvantages.

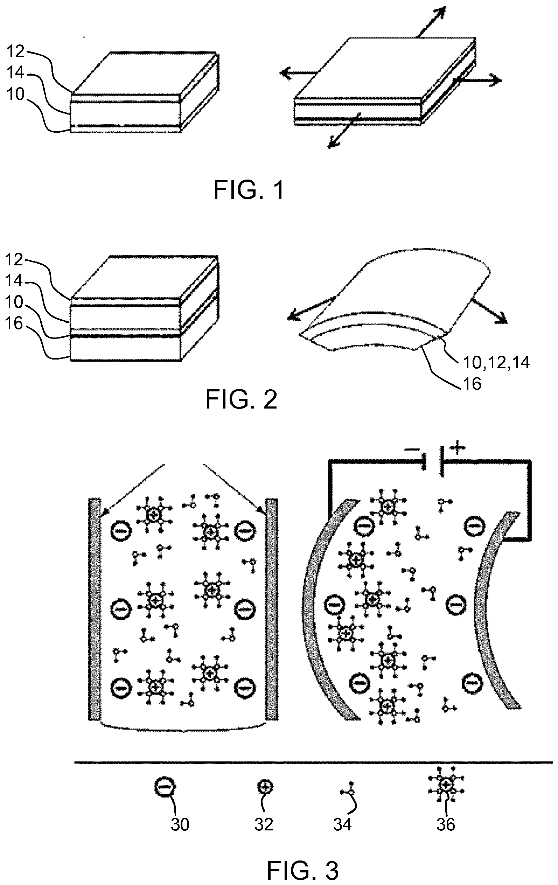

Figures 1 and 2 show two possible operating modes for an EAP device.

The device comprises an electroactive polymer layer 14 sandwiched between electrodes 10, 12 on opposite sides of the electroactive polymer layer 14.

Figure 1 shows a device which is not clamped. A voltage is used to cause the electroactive polymer layer to expand in all directions as shown.

Figure 2 shows a device which is designed so that the expansion arises only in one direction. The device is supported by a carrier layer 16. A voltage is used to cause the electroactive polymer layer to curve or bow.

The nature of this movement for example arises from the interaction between the active layer which expands when actuated, and the passive carrier layer. To obtain the asymmetric curving around an axis as shown, molecular orientation (film stretching) may for example be applied, forcing the movement in one direction.

The expansion in one direction may result from the asymmetry in the electroactive polymer, or it may result from asymmetry in the properties of the carrier layer, or a combination of both.

The electrodes in Figures 1 and 2 for example create an electric field for a field-driven device.

Figure 3 shows an example of a current driven ionic device. The actuation mechanism involves the diffusion of ions and/or electrochemical oxidation and reduction. Figure 3 shows the structure of an Ionic Polymer Metal Composite (IPMC). There are fixed anions 30, movable cations 32 and water molecules 34 which attach to the cations to form hydrated cations. These move in response to an applied actuation signal.

EAP actuators are typically formed as bending actuators. They may for example be clamped at first edge, with the actuator projecting from that edge. The projecting part then bends in response to actuation, and the actuation part is for example the remote tip. A double-clamped arrangement is clamped at opposing edges and is caused to bow in response to actuation. The actuation part is then for example the middle of the structure.

EAPs can also be used as sensors using piezoelectric or pressure induced ionic diffusion based read out. This sensing is based on the fact that a contact pressure leads to a voltage output.

There is a desire for improved versatility of responsive material based actuators, in particular the operation modes, for instance to control precisely the level of deformation.

The ionic electroactive polymer actuators have a distinct advantage when used in the human body, that they can be operated by low voltage. Especially when such an actuator is used for miniaturized devices, i.e. interventional medical devices (IMDs) such as catheters and guidewires, the measurement and control system should be very small. Often there is no space to position an external feedback system.

This invention relates in particular to ionic electroactive polymer actuators. There is a particular need for a feedback and control system for an ionic electroactive polymer actuator so as to enable more accurate actuation control.

It is known that when such an actuator is activated, the impedance of the ionic electroactive polymer changes and that this can be probed by an electrical signal without impairing or changing the actuation level. This impedance is a measure for the level of deflection.

This general sensing approach is known but is accompanied with drawbacks. For example, feedback may be based on an ionic electroactive polymer sandwiched by two electrodes, a low voltage DC source and an AC low voltage source in line with a current meter (ammeter).

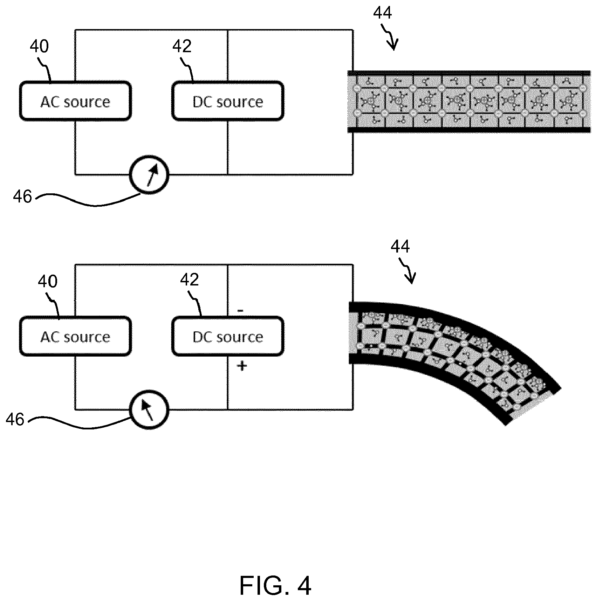

An example of the possible electrical circuit is shown in Figure 4, wherein the top image shows the non-actuated state and the bottom image shows the actuated state.

The actuator is operated by an AC source 40 and a DC source 42 in parallel and connected to the electrodes of the actuator 44. The ammeter 46 measures the current flowing between the AC source 40 and the DC source 42.

In the top image, the DC source 42 is off and no DC voltage is applied. The AC source 40 applies a voltage in combination with a sufficiently high frequency that the ionic electroactive polymer actuator 44 does not show an observable deflection. Since the cations are distributed over the bulk of the electroactive polymer the electrical impedance is relatively low and the ammeter measures an AC electrical current. From the AC voltage and current the electrical impedance of the electroactive polymer can be determined.

In the bottom image, the DC source 42 is on and a DC voltage is applied over the actuator which in response deflects. In parallel, the AC source 40 applies a voltage in combination with a sufficiently high frequency that the ionic electroactive polymer actuator 44 again will not show an observable additional deflection by virtue of the AC source. Since the cations have migrated to the cathode of the actuator, the bulk of the electroactive polymer is deprived of mobile cations and the electrical impedance is relatively high. The ammeter measures only a low AC electrical current.

A problem with this basic approach is that the electrical signals need to be extremely small to avoid heating of the device. Because the impedance changes are also small, the sensing signal is difficult to measure accurately and these small signals are prone to noise, especially over large distances, and from disturbance of the relatively large DC signal, which complicates measurement.

### SUMMARY OF THE INVENTION

There is therefore a need for an improved feedback and control system for an ionic electroactive polymer actuator.

It is an object of the current invention to fulfill the aforementioned need at least partially. This object is achieved at least partially by the device and method as defined by the independent claims. The dependent claims provide advantageous embodiments.

According to examples in accordance with an aspect of the invention, there is provided an actuator device comprising:
an ionic electroactive material actuator unit comprising a membrane with first and second actuation electrodes for receiving a DC drive signal; and
a pair of measurement electrodes on a first surface of the membrane for measurement of an electrical parameter, wherein the measurement electrodes are spaced apart by a spacing (d) which is less than ten times the thickness (h) of the membrane in the vicinity of the measurement electrodes.

This device enables sensing the actuation level of the device by measuring an electrical parameter, such as the impedance, based on a pair of closely spaced measurement electrodes on the same side of the membrane. The actuation of the device causes migration of charges from one side of the membrane towards the other, so the impedance measurement (which may for example be based on measurement of current at a known voltage), is most sensitive at the surfaces of the membrane. For example, actuation causes a depletion of mobile cations from the anode, and they collect at the cathode. A relatively large change in impedance results, so that a low measurement current is needed. This minimizes undesired heating effects.

The spacing is preferably less than less than 5 times, preferably less than 2 times, preferably less than one times the thickness (h) of the membrane in the vicinity of the measurement electrodes. Thus, the measurement of the electrical parameter relates primarily to the measurement of a surface effect rather than a bulk effect.

The first and second actuation electrodes may be on opposite first and second surfaces, respectively, of the membrane. However, they may also be on one side, for example in the form of interdigitated electrodes.

The actuator device preferably also comprises:
a DC signal source for applying the DC drive signal between the actuation electrodes;
a measurement signal source for applying a measurement signal to the pair of measurement electrodes; and
a measurement device for measuring an electrical parameter resulting from the measurement signal.

Thus, the device comprises the suitably designed actuator membrane as well as the signal source and measurement apparatus, for actuating the membrane and providing position sensing feedback.

The measurement electrodes are for example provided in a channel formed in the first actuation electrode thereby electrically isolated from the first actuation electrode. In this case, the first side of the membrane has at least one of the actuation electrodes as well as a pair of measurement electrodes formed in an isolated channel area. The measurement electrodes are closely spaced so do not require a large channel in the actuation electrode, and the actuation function is therefore minimally impeded.

The measurement electrodes may instead be provided in a separating channel formed between first and second physically separate portions of the first actuation electrode, thereby electrically isolated from the first and second portions. In this way, the first actuation electrode is formed of physically separate, but electrically connected, portions, with the measurement electrodes in the spacing between those actuation electrode portions.

If the actuation electrodes are on the same side of the membrane, the measurement electrodes may then be provided in a separating channel formed between first and second actuation electrodes.

In these examples, the measurement signal source is for example coupled to the pair of measurement electrodes and the DC signal source is coupled to the first and second actuation electrodes. Thus, the DC driving and the sensing are separate independent functions.

In a different set of examples, the measurement electrodes comprise first and second separate portions of the first actuation electrode. In this way, the first actuation electrode itself is used as the pair of measurement electrodes, by providing a pair of narrowly spaced portions.

In one example, the first and second separate portions together form an interlocking comb structure. The gap then defines a serpentine track. In another example, the measurement electrodes comprise a first set of electrically connected first portions of the first actuation electrode and a second set of electrically connected second portions of the first actuation electrode, wherein the first and second sets are interleaved. The first and second portions may comprise straight lines, in which case the measurement gap is formed as a set of lines.

In these examples, the measurement signal source is for example coupled to the pair of measurement electrodes and the DC signal source is coupled to the first portion of the first actuation electrode and the second actuation electrode. In this way, the DC drive signal is provided between the one of the actuation electrode portions and the opposite actuation electrode, whereas the DC drive signal and a superposed measurement signal is provided between the other of the actuation electrode portions and the opposite actuation electrode. The voltage across the gap is the measurement signal.

There may be a plurality of pairs of measurement electrodes, for example for measuring an actuation response at different locations.

The device preferably further comprises a controller for controlling the actuator unit based on the measured electrical parameter. Thus, the measurement is used as a feedback control mechanism to allow the device to be actuated to desired actuation levels with increased accuracy.

The controller may comprise a processor, a digital to analog converter for providing a DC drive signal to the DC signal source and an analog to digital converter for providing an electrical parameter measurement signal.

The measurement signal source for example comprises an AC voltage source. The measured electrical parameter for example relates to the local impedance of the membrane in the vicinity of the gap. The electroactive material actuator unit is a current-driven actuator, and for this purpose the DC signal source for example comprises a current-limited DC voltage source which is controllable to alter the current flowing.

In a preferred example, the first actuation electrode is the anode for the DC signal source and the second electrode is the cathode for the DC signal source. Thus, the impedance change relates to the migration of charges between the cathode and anode when the device is actuated. This provides a strong and quickly responding impedance change in response to actuation of the device.

The electroactive material actuator unit is for example an ionic polymer metal composite actuator.

### BRIEF DESCRIPTION OF THE DRAWINGS

Examples of the invention will now be described in detail with reference to the accompanying drawings, in which:
Figure 1 shows a known electroactive polymer device which is not clamped;
Figure 2 shows a known electroactive polymer device which is constrained by a backing layer;
Figure 3 shows a current driven ionic electroactive polymer device;
Figure 4 shows one possible actuation and measurement system;

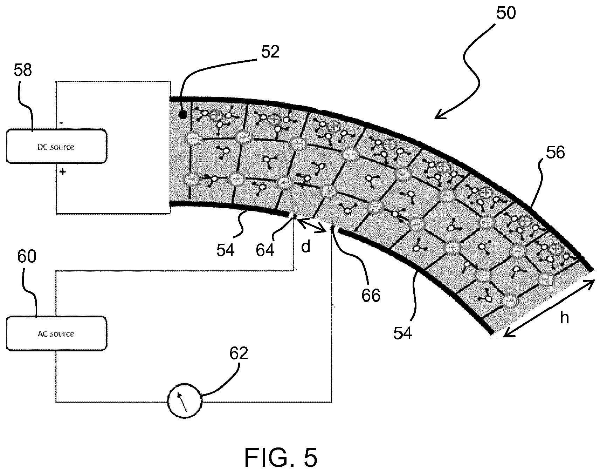

Figure 5 shows a first example of an electroactive material actuator device in accordance with the invention;

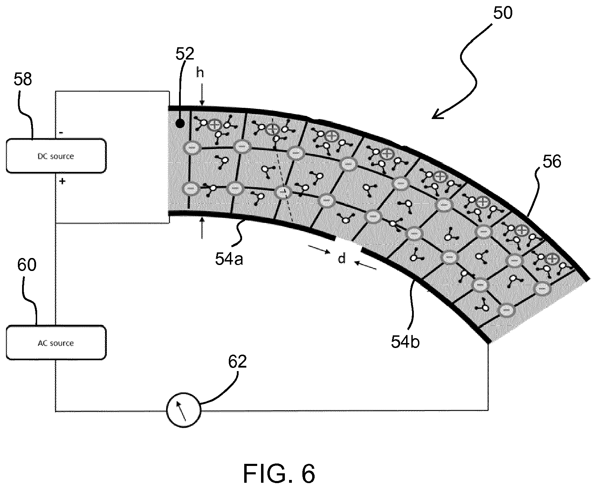

Figure 6 shows a second example of an electroactive material actuator device in accordance with the invention;

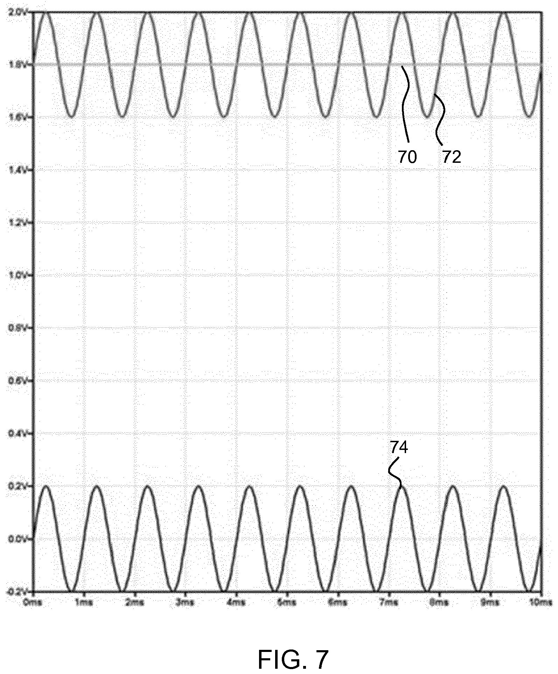

Figure 7 shows electrode signals present in the device of Figure 6;

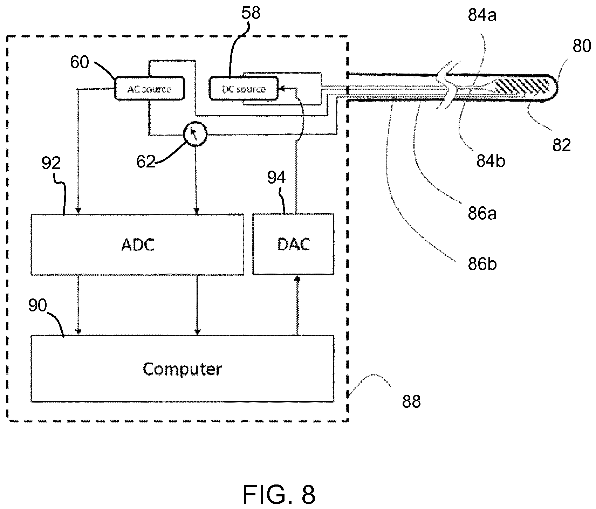

Figure 8 shows a drive circuit and feedback system for the electroactive material actuator device of Figure 5;

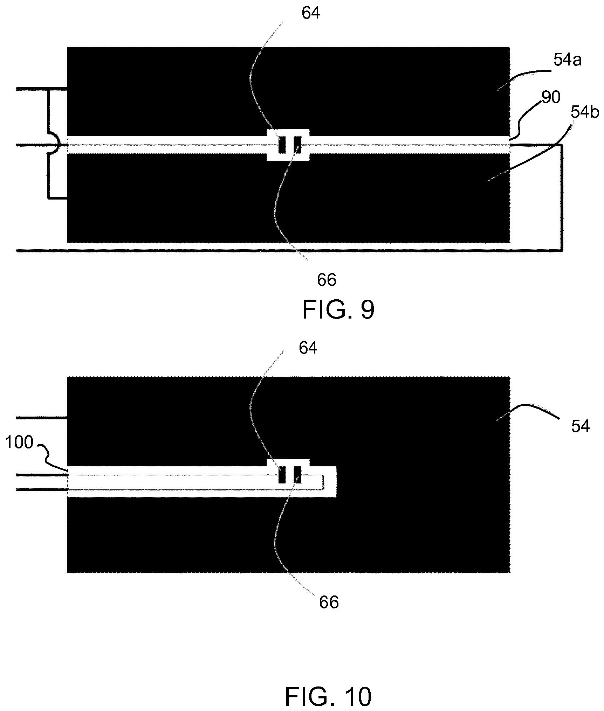

Figure 9 shows a first electrode design for the electroactive material actuator device of Figure 5;
Figure 10 shows a second electrode design for the electroactive material actuator device of Figure 5;

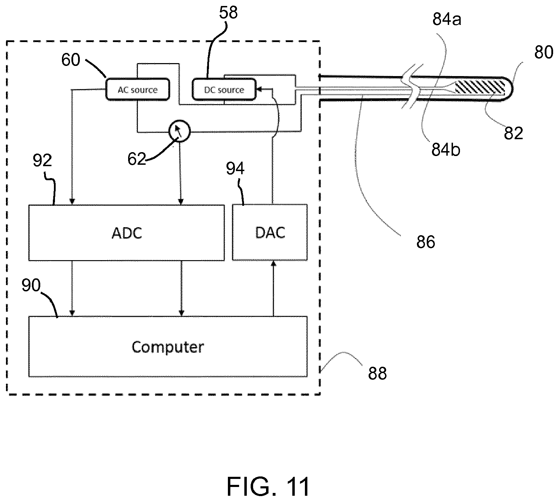

Figure 11 shows a drive circuit and feedback system for the electroactive material actuator device of Figure 6;

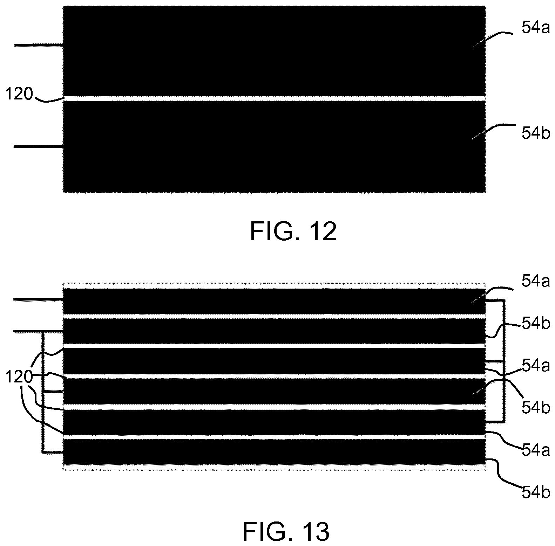

Figure 12 shows a first electrode design for the electroactive material actuator device of Figure 6;
Figure 13 shows a second electrode design for the electroactive material actuator device of Figure 6

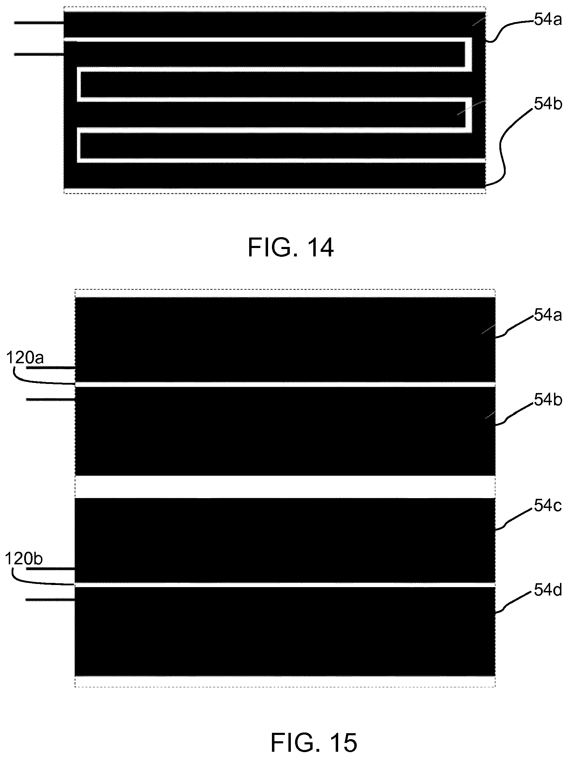

Figure 14 shows a third electrode design for the electroactive material actuator device of Figure 6;
Figure 15 shows a fourth electrode design for the electroactive material actuator device of Figure 6; and

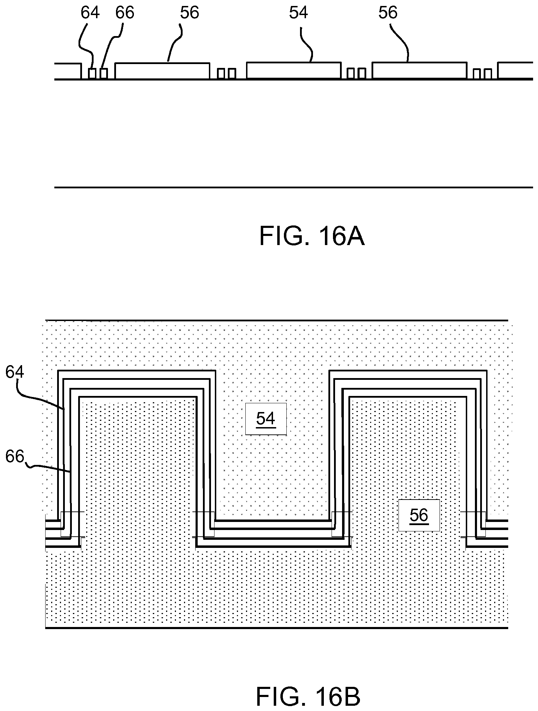

Figure 16 shows a further design with all electrodes on one side of the membrane.

### DETAILED DESCRIPTION OF THE EMBODIMENTS

The invention will be described with reference to the Figures.

It should be understood that the detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. It should be understood that the Figures are merely schematic and are not drawn to scale. It should also be understood that the same reference numerals are used throughout the Figures to indicate the same or similar parts.

The invention provides an actuator device which has an ionic electroactive material actuator unit comprising a membrane with first and second actuation electrodes on opposite first and second surfaces, respectively. A DC drive signal is applied between the actuation electrodes. In addition, a pair of closely spaced measurement electrodes is provided on the first surface of the membrane. A local surface-effect impedance change is preferably used as the basis of a signal measurement, for providing feedback relating to the state of actuation of the device.

Figure 5 shows a first example of an electroactive material actuator device in accordance with the invention.

It comprises an ionic electroactive material actuator unit 50 comprising a membrane 52 with first and second actuation electrodes 54, 56 which in this example are on opposite first and second surfaces, respectively, of the membrane 52.

A DC signal source 58 is used to apply a DC drive signal between the actuation electrodes 54, 56. The actuator unit is a current driven device, and the DC signal source 58 is a current limited voltage source, with controllable voltage thereby to result in different current flowing and hence different actuation levels. The DC signal source can have either polarity, but does not alternate during the driving. The DC signal source could instead be a current source with both a current limiter and a voltage limiter, or even capacitor discharge circuit with current limiter.

The function of the current limited DC voltage source is to bring the device to a pre-defined voltage state but without exceeding a specific current. The primary reason for this is to avoid damage to the device at excessive currents. Of course, there are several electrical equivalents to achieve the same driving approach.

By way of example, there may be a peak current limit of 20mA/cm². The desired sustain current depends on the type of ionic EAP.

A measurement signal source 60 is used to apply a measurement signal. This is preferably an AC signal source for applying an AC voltage. The voltage for the measurement signal is for example below 0.1V (which is for example less than 10% of the actuation voltage) and with a frequency typically above 1kHz. The measurement signal is intended to have no, or minimal, influence on the actuation achieved by the DC signal of the DC signal source.

A current measurement device 62 is provided for measuring an impedance, based on the current resulting from the measurement signal. It has a response time able to measure at the frequency of the measurement signal.

The measurement signal is applied to a pair of measurement electrodes 64, 66 on the first surface of the membrane. The measurement electrodes 64.66 are spaced apart by a spacing d which is at most ten times the thickness h of the membrane in the vicinity of the measurement electrodes.

By this is meant that the thickness is the thickness at the location of the measurement electrodes or at the location of the spacing between the measurement electrodes, since for example the membrane may not have perfectly uniform thickness over its full area. The spacing is preferably less than 5 times, or two times or even one times the thickness. The spacing is for example in the range 10 to 20 µm as this is compatible with processing of relatively large area devices and leaves more area for the actuation electrodes. Thus, "in the vicinity of the measurement electrodes" may for example mean at a location which is anywhere within the spacing between the measurement electrodes.

The thickness is for example in the range 10 µm to 500 µm for example in the range 50 µm to 300 µm.

Thus, although Figure 5 shows d less than h as a preferred implementation, advantages are obtained even when d exceeds h. The measurement is still predominantly of the surface effect rather than based on the path which passes twice across the bulk of the device.

When the distance between the measurement electrodes is decreased, the impedance rate of change will be increased.

In this design, the current measurement implements an impedance measurement which is in turn a measure of the level of actuation (i.e. bending in the example as shown in Figure 5).

The measurement electrodes 64, 66 are on one side of the actuator, and thereby capable of measuring a local impedance change of the actuator close to these electrodes, so measuring an impedance change close to the side of the actuator. The measurement electrodes are for example located on the anode site of the actuator. The area close to these electrodes will be depleted rather quickly from the mobile cations. This will result in a fast impedance change rate. Moreover since the gap d between the measurement electrodes 64, 66 is small, the change in impedance is relatively large allowing the use of a low AC current and thereby minimizing local heating. A more precise control of the deflection is thereby obtained.

In the example of Figure 5, the AC signal source 60 is coupled to the pair of measurement electrodes and the DC signal source 58 is coupled to the first and second actuation electrodes. Thus, the DC driving and AC sensing are separate independent functions and the measurement electrodes are used to form an independent electrical circuit to the circuit used for actuation.

The measurement electrodes are shown in a gap formed in the actuation electrode 54. As will be described further below, this gap may be a closed channel (i.e. a recess) formed in the first actuation electrode or it may be an open separating channel formed between first and second physically separate portions of the first actuation electrode. In this case, the two electrode portions are electrically connected and have the same applied voltage.

Figure 6 shows a second example of an electroactive material actuator device in accordance with the invention.

It shows the same DC signal source 58 and AC signal source 60 but with a different electrode arrangement.

In this design, the measurement electrodes are defined by two electrically isolated portions 54a, 54b of the first actuation electrode, for example a split anode. The first actuation electrode itself is used to define the pair of measurement electrodes, by providing a pair of narrowly spaced portions. The spacing d meets the same rules as outlined above.

The voltage difference between the second actuation electrode 56 (cathode) and the first portion 54a of the first actuation electrode (anode) is determined by the voltage resulting from the DC signal source 58. The voltage difference between the second actuation electrode 56 and the second portion 54b of the first actuation electrode is determined by the voltage resulting from the DC signal source 58 superimposed with the voltage as delivered by the AC signal source 60. Hence, the voltage difference between the two electrode portions across the gap (with width d) is the voltage as delivered by the AC signal source.

In principle, the level of actuation at the location of the first and second portions 54a, 54b is different. However when the frequency of the AC signal is high, the ions only vibrate over a very small distance and no net actuation due to the AC signal will occur, equalizing the level of actuation between the portions 54a, 54b. The time averaged voltage of the first and second electrode portions is equal.

Figure 7 shows electrode signals present in the device of Figure 6. Plot 70 is the voltage between the second actuation electrode (cathode) 56 and the first anode portion 54a, plot 72 is the voltage between the second actuation electrode (cathode) 56 and the second anode portion 54b, and Plot 74 is the AC voltage between the two electrode portions 54a, 54b. In this example, the voltage of the DC signal source 58 was chosen to be 1.8 Volt and the peak to peak difference of the AC voltage provided by the AC signal source 60 was chosen to be 0.4 Volt.

The circuits described above both operate using a feedback system which is based on a property change of the electroactive material itself, namely the electrical impedance, and no external measuring sensor is required, such as for example a mechanical displacement measuring device. Only an AC source and current meter is sufficient. Since these are connected via electrical wires, the AC and DC signal sources and the current meter can be placed in a peripheral position with respect to the actuator. This enables the use of optimal miniaturized actuators that can be precisely controlled.

Figure 8 shows a drive circuit and feedback system for the electroactive material actuator device of Figure 5. The device is shown as part of a steerable catheter system (although more generally it may be any interventional medical device such as a guidewire), having a catheter 80 and the actuator device 82 formed at the tip of the catheter for providing steering.

A first pair of wires 84a, 84b connect the device 82 to the DC signal source 58 and a second pair of wires 86a, 86b connect the device 82 to the AC signal source 60.

A feedback circuit 88 has the AC and DC signal sources connected as shown in Figure 5.

The AC voltage and AC current values are fed into a processor 90 via an Analog to Digital converter 92 and in the processor a software program receives these values as function of time and calculates the electrical impedance of the actuator.

The AC source is for example set to a fixed voltage for the impedance measurement function. The voltage may thus already be known to the processor 90 and hence does not need to be reported, or it may be reported as shown to ensure accurate impedance measurement.

Via a look up table, the software program determines the deflection of the actuator tip and can also predict a final deflection. If the final deflection will be beyond or below the desired deflection, the voltage of the DC signal source 58 may be adapted, by feeding a signal to the DC signal source via a Digital to Analog converter 94, until the desired deflection of the actuator tip has been obtained.

These calculations are very fast and for a person operating the device, this happens in real time. Moreover the operator can manually influence the software program if the deflection has to be changed to another level. The latter for instance may arise when a blood vessel bifurcation has been passed and the tip of the device reaches a straight part of the blood vessel. In more sophisticated systems the adaption to the desired deflection level can be derived from a 3D image of the blood vessel bed through which the device is traversed.

In this way, a precise and fast control of the deflection is achieved. In this manner, the deflection of the actuator can be controlled to avoid an unintentional piercing of a blood vessel wall by the actuator tip due to bending. For example, in the case of attempting to traverse a chronic total occlusion a timely feedback may be generated to prevent a too large deflection which may pierce the blood vessel wall.

Figure 9 shows a first electrode design for the electroactive material actuator device of Figure 5. It shows the the measurement electrodes 64, 66 provided in a separating channel 90 formed between first and second physically separate portions 54a, 54b of the first actuation electrode, thereby electrically isolated from the first and second portions 54a, 54b.

Figure 10 shows a second electrode design for the electroactive material actuator device of Figure 5. It shows the measurement electrodes 64, 66 provided in a channel 100 formed in the first actuation electrode 54 thereby electrically isolated from the first actuation electrode. The channel 100 is closed so just forms an indentation or recess into the main area of the electrode.

The aspect ratio of the actuator can be adapted to any shape required for a particular application.

Figure 11 shows a drive circuit and feedback system for the electroactive material actuator device of Figure 6.

The device is again shown as part of a steerable catheter system, having a catheter 80 and the actuator device 82 formed at the tip of the catheter for providing steering.

A first pair of wires 84a, 84b connect the device 82 to the DC signal source 58 with one of the wires connecting also to the AC signal source 60, and a second wire 86 provides the second connection of the device 82 to the AC signal source 60.

The feedback circuit 88 has the AC and DC signal sources connected as shown in Figure 6. As in Figure 8, the AC voltage and AC current values are fed into a processor 90 via an Analog to Digital converter 92 and in the processor a software program receives these values as function of time and calculates the electrical impedance of the actuator. This arrangement provides the same functionality and advantages as described above with reference to Figure 8.

Figure 12 shows a first electrode design for the electroactive material actuator device of Figure 6.

The measurement electrodes comprise first and second separate portions 54a, 54b of the first actuation electrode. In this example the portions are rectangles forming a linear gap 120 across which the measurement signal is measured.

Figure 13 shows a second electrode design for the electroactive material actuator device of Figure 6.

The measurement electrodes comprise a first set of electrically connected first portions 54a of the first actuation electrode and a second set of electrically connected second portions 54b of the first actuation electrode, wherein the first and second sets are interleaved. This forms a set of parallel linear gaps 120 so that the measurement function is distributed over the actuator area. The measurement gaps thus cover a larger part of the actuator generating a larger sensing signal.

Figure 14 shows a third electrode design for the electroactive material actuator device of Figure 6. The first and second separate portions together form an interlocking comb structure.

Figure 15 shows a fourth electrode design for the electroactive material actuator device of Figure 6. It shows two pairs of measurement measurement electrodes, formed by gaps 120a and 120b so four portions 54a - 54d of the first actuation electrode. This enables independent feedback measurement from multiple locations. Detection of local actuation may for example be interesting when the actuator is locally blocked and this can be recorded with a multitude of electrode pairs.

There may similarly be multiple pairs of measurement electrodes for the design of Figure 5. When multiple measurement electrode pairs are used, multiple current measurement circuits are of course required.

The aspect ratio of the actuator can again be adapted to every shape required for a particular application.

The examples above all show actuation electrodes on opposite sides of the membrane. Figure 16 shows an example with the actuation electrodes 54, 56 and the measurement electrodes 64, 66 on the same, single, side of the membrane.

Figure 16A shows a cross sectional view and Figure 16B shows a plan view. The two actuation electrodes 54, 56 are formed as interdigitated comb electrodes. The pair of measurement electrodes follow a meandering path in the space between the two actuation electrodes.

This actuator design could switch from a flat surface texture (non-activated) to either a corrugated surface texture (if there is no substrate) or alternatively a wavy shape with alternative bending directions (if there is a rigid substrate), when viewed in the cross section of Figure 16A.

The measurement electrodes are able to determine the state of actuation of the actuator by measuring the change of impedance of the region between the actuator electrodes.

There may also be a single separate measurement electrode so that one of the actuator electrodes functions as one of the pair of measurement electrodes (as is also the case in Figure 6). The impedance is then measured between the one additional measurement electrode and the electrode where mobile carriers are removed.

In all designs above, the cathode and anodes may be switched when a deflection in the opposite direction is required. An electrical impedance change can still be measured over the special electrodes, only in this case a fast decrease in impedance is measured.

It is also possible to provide measurement electrodes on both sides of the membrane. In this case, an increase of electrical impedance may be measured at the anode side and a decrease at the cathode side. The difference between these values may constitute an even faster response when a certain threshold is determined due to noise.

In fact the impedance between the measurement electrodes is determined by the impedance of the ionic electroactive material but also by the impedance of the air. In the case that the impedance is dominantly determined by the resistance (i.e. the real part of the impedance), the AC signal source in the electric circuits could be replaced by a DC source.

However in general AC sensing signals, for measuring an imaginary impedance component (inductance/capacitance) have a better signal to noise ratio, especially when the AC signal can be isolated via an electrical filter (i.e. lock-in amplifier).

The choice between the designs of Figures 5 and 6 will depend on requirements of particular designs. For instance, Figure 5 may be preferred when a high precision is required, since the DC and AC electrical circuits can be independent from each other and hence can be optimized. Figure 6 may be preferred when there is limited space for electrical wires.

Note that several actuators may be integrated into an interventional medical device over the length of the device. For instance, three actuators may be provided and for each actuator a similar scheme is used as described above, for example based on Figure 6 to reduce the number of wires. In this case, for actuation the actuators can have one common line and each require one return line to be able to actuate them separately. For the sensing part an additional wire per actuator is required. This constitutes a total of 7 wires.

The approach of Figure 5 would also allow one common line for actuation and one common line for AC sensing, constituting a total of 8 wires that is needed to connect the actuators. Alternatively when a proper addressing system is used, the number of lines may be reduced. This is especially useful if an increasing number of actuators is in demand. With individually controlled actuators the IMD device can make more complicated bends which is useful to traverse tortuous blood vessels.

In all examples, the electroactive material actuator is based on an ionic (current driven) electroactive polymer material.

Examples of ionic-driven EAPs are conjugated polymers, carbon nanotube (CNT) polymer composites and Ionic Polymer Metal Composites (IPMC).

The sub-class conjugated polymers includes, but is not limited to:
polypyrrole, poly-3,4-ethylenedioxythiophene, poly(p-phenylene sulfide), polyanilines.

The materials above can be implanted as pure materials or as materials suspended in matrix materials. Matrix materials can comprise polymers.

To any actuation structure comprising EAM material, additional passive layers may be provided for influencing the behavior of the EAM layer in response to an applied drive signal.

The actuation arrangement or structure of an EAM device can have one or more electrodes for providing the control signal or drive signal to at least a part of the electroactive material. Preferably the arrangement comprises two electrodes. The EAM layer may be sandwiched between two or more electrodes. This sandwiching is needed for an actuator arrangement that comprises an elastomeric dielectric material, as its actuation is among others due to compressive force exerted by the electrodes attracting each other due to a drive signal. The two or more electrodes can also be embedded in the elastomeric dielectric material. Electrodes can be patterned or not.

It is also possible to provide an electrode layer on one side only for example using interdigitated comb electrodes.

A substrate can be part of the actuation arrangement. It can be attached to the ensemble of EAP and electrodes between the electrodes or to one of the electrodes on the outside.

The electrodes may be stretchable so that they follow the deformation of the EAM material layer. This is especially advantageous for EAP materials. Materials suitable for the electrodes are also known, and may for example be selected from the group consisting of thin metal films, such as gold, copper, or aluminum or organic conductors such as carbon black, carbon nanotubes, graphene, poly-aniline (PANI), poly(3,4-ethylenedioxythiophene) (PEDOT), e.g. poly(3,4-ethylenedioxythiophene) poly(styrenesulfonate) (PEDOT:PSS). Metalized polyester films may also be used, such as metalized polyethylene terephthalate (PET), for example using an aluminum coating.

The materials for the different layers will be selected for example taking account of the elastic moduli (Young's moduli) of the different layers.

Additional layers to those discussed above may be used to adapt the electrical or mechanical behavior of the device, such as additional polymer layers.

There are many uses for electroactive material actuators and sensors. In many applications the main function of the product relies on the (local) manipulation of human tissue, or the actuation of tissue contacting interfaces. In such applications EAP actuators provide unique benefits mainly because of the small form factor, the flexibility and the high energy density. Hence EAPs can be easily integrated in soft, 3D shaped and / or miniature products and interfaces. Examples of such applications are:
Skin cosmetic treatments such as skin actuation devices in the form of EAP based skin patches which apply a constant or cyclic stretch to the skin in order to tension the skin or to reduce wrinkles;
Respiratory devices with a patient interface mask which has an EAP based active cushion or seal, to provide an alternating normal pressure to the skin which reduces or prevents facial red marks;
Electric shavers with an adaptive shaving head. The height of the skin contacting surfaces can be adjusted using EAP actuators in order to influence the balance between closeness and irritation;
Oral cleaning devices such as an air floss with a dynamic nozzle actuator to improve the reach of the spray, especially in the spaces between the teeth. Alternatively, toothbrushes may be provided with activated tufts;
Consumer electronics devices or touch panels which provide local haptic feedback via an array of EAP transducers which is integrated in or near the user interface;
Catheters with a steerable tip to enable easy navigation in tortuous blood vessels. The actuator function for example controls the bending radius to implement steering, as explained above.

Another category of relevant application which benefits from EAP actuators relates to the modification of light. Optical elements such as lenses, reflective surfaces, gratings etc. can be made adaptive by shape or position adaptation using EAP actuators. Here the benefits of EAP actuators are for example the lower power consumption.

Some examples where asymmetric stiffness control is of interest are outlined below.

Actuators may be used in valves, including human impantables such as prosthetic heart valves or valves in organ-on-chip applications or microfluidic devices. For many valves, an asymmetric behavior is desired: compliant and large displacement in a direction with the flow, and stiff in a direction against the flow. Sometimes high actuation speed is required to close a valve quickly.

A flexible display actuator is desired in some applications, for example in smart bracelets. When the flexible display moves to another position or shape for better reading or visual performance, a large displacement is required. When the display is in its rest position, the display actuator must be stiff to hold its position firmly.

There are also application is noise and vibration control systems. Using stiffness variation, it is possible to move away from resonance frequencies and hence reduce vibrations. This is useful for example in in surgery robotic tools where precision is important.

Soft robotics (artificial muscle systems supporting the human body) for example is used to support or hold a body part in a certain position (e.g. against gravity), during which stiffness is required. When the body part moves in the opposite direction resistance is not required and low stiffness is desirable.

A segmented catheter application may also benefit from variable stiffness. For example, when the catheter tip bends around a corner, it is desired that the segment just behind the tip is temporarily compliant such that the rest of the catheter follows the tip.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. An actuator device comprising:
an ionic electroactive material actuator unit (50) comprising a membrane (52) with first and second actuation electrodes (54, 56) for receiving a DC drive signal; and
a pair of measurement electrodes (64,66; 54a,54b) on a first surface of the membrane for measurement of an electrical parameter, wherein the measurement electrodes are spaced apart by a spacing (d) which is less than ten times the thickness (h) of the membrane in the vicinity of the measurement electrodes.

2. An actuator device as claimed in claim 1, wherein the spacing (d) is less than 5 times, preferably less than 2 times, preferably less than one times the thickness (h) of the membrane in the vicinity of the measurement electrodes.

3. An actuator device as claimed in claim 1 or 2, wherein the first and second actuation electrodes (54, 56) are on opposite first and second surfaces, respectively, of the membrane.

4. An actuator device as claimed in any one of claims 1 to 3, comprising:
a DC signal source (58) for applying the DC drive signal between the actuation electrodes;
a measurement signal source (60) for applying a measurement signal to the pair of measurement electrodes; and
a measurement device (62) for measuring an electrical parameter resulting from the measurement signal.

5. An actuator device as claimed in claim 4, wherein the measurement signal source (60) is coupled to the pair of measurement electrodes and the DC signal source is coupled to the first and second actuation electrodes.

6. An actuator device as claimed in claim 4, wherein:
the measurement electrodes (64,66) are provided in a channel (100) formed in the first actuation electrode thereby electrically isolated from the first actuation electrode; or
the measurement electrodes (64,66) are provided in a separating channel (90) formed between first and second physically separate portions of the first actuation electrode, thereby electrically isolated from the first and second portions; or
the measurement electrodes are provided in a separating channel (90) formed between first and second actuation electrodes.

7. An actuator device as claimed in claim 6, wherein the measurement electrodes comprise first and second separate portions (54a, 54b) of the first actuation electrode (54).

8. An actuator device as claimed in claim 7, wherein:
the first and second separate portions together form an interlocking comb structure; or
the measurement electrodes comprise a first set of electrically connected first portions of the first actuation electrode and a second set of electrically connected second portions of the first actuation electrode, wherein the first and second sets are interleaved.

9. An actuator device as claimed in claim 7 or 8, wherein the measurement signal source is coupled to the pair of measurement electrodes and the DC signal source is coupled to the first portion of the first actuation electrode and the second actuation electrode.

10. An actuator device as claimed in any one of claims 1 to 9, comprising a plurality of pairs of measurement electrodes.

11. An actuator device as claimed in any one of claims 1 to 10, further comprising a controller (88) for controlling the actuator unit based on the measured electrical parameter.

12. An actuator device as claimed in claim 11, wherein the controller comprises a processor (90), a digital to analog converter (94) for providing a DC drive signal to the DC signal source and an analog to digital converter (92) for providing a measurement electrical parameter signal and the device further comprises an AC voltage source as a measurement signal source (60).

13. An actuator device as claimed in any one of claims 1 to 12, wherein the electroactive material actuator unit is a current-driven actuator, and the device further comprises a current-limited DC voltage source as a DC signal source.

14. An actuator device as claimed in any one of claims 1 to 13, wherein the first actuation electrode is the anode for the DC drive signal and the second electrode is the cathode for the DC drive signal.

15. A device as claimed in any one of claims 1 to 14, wherein the electroactive material actuator unit is an ionic polymer metal composite actuator.
